# EUROPÄISCHE PATENTSCHRIFT

(11) **EP 1 421 612 B1**
(45) Veröffentlichungstag und Bekanntmachung des Hinweises auf die Patenterteilung: **22.04.2009**
(21) Anmeldenummer: 02794797.7
(22) Anmeldetag: 16.08.2002
(51) Int. Cl.: H01L 21/336, H01L 29/78, H01L 29/06, H01L 29/08

(54) **LDMOS-Transistor und dessen Herstellungsverfahren**
LDMOS Transistor and method of fabricating the same
Transistor LDMOS et son procédé de fabrication

(30) Priorität: 17.08.2001 DE 10140628; 07.09.2001 DE 10145212
(43) Veröffentlichungstag der Anmeldung: 26.05.2004
(73) Patentinhaber: IHP GmbH-Innovations for High Performance Microelectronics/Institut für innovative Mikroelektronik, 15236 Frankfurt an der Oder (DE)
(72) Erfinder: EHWALD, Karl-Ernst, 15234 Frankfurt (Oder) (DE); RÜCKER, Holger, 15526 Bad Saarow (DE); HEINEMANN, Bernd, 15234 Frankfurt(Oder) (DE)
(74) Vertreter: Eisenführ, Speiser & Partner
(86) Internationale Anmeldenummer: PCT/EP2002/009184
(87) Internationale Veröffentlichungsnummer: WO 2003/017349

(56) Entgegenhaltungen:
- EP-A- 0 295 391
- DE-A- 4 336 054
- US-A- 5 311 051
- US-A- 5 763 927
- PATENT ABSTRACTS OF JAPAN vol. 2000, no. 16, 8. Mai 2001 (2001-05-08) -& JP 2001 015741 A (TOSHIBA CORP), 19. Januar 2001 (2001-01-19)
- PATENT ABSTRACTS OF JAPAN vol. 016, no. 347 (E-1240), 27. Juli 1992 (1992-07-27) -& JP 04 107871 A (MATSUSHITA ELECTRON CORP), 9. April 1992 (1992-04-09)
- PATENT ABSTRACTS OF JAPAN vol. 004, no. 157 (E-032), 4. November 1980 (1980-11-04) -& JP 55 108773 A (NEC CORP), 21. August 1980 (1980-08-21)
- PATENT ABSTRACTS OF JAPAN vol. 010, no. 016 (E-375), 22. Januar 1986 (1986-01-22) -& JP 60 177677 A (SUWA SEIKOSHA KK), 11. September 1985 (1985-09-11)

## Beschreibung

Die Erfindung betrifft einen lateralen DMOS-Transistor, kurz LDMOS-Transistor, insbesondere einen CMOS-kompatiblen RF-LDMOS-Transistor mit niedrigem "on" Widerstand, sowie ein Verfahren zu dessen Herstellung.

Ein DMOS-Transistor zeichnet sich gegenüber einem herkömmlichen MOS-Transistor (**M**etal-**O**xid **S**emiconductor Transistor) dadurch aus, dass zwischen der Kante des Steuergates und dem Drain-Bereich des Transistors eine Drift-Zone vorgesehen ist, d. h. eine Zone, in der die Bewegung der Ladungsträger nur durch ein zwischen den gegenüberliegenden Enden der Zone anliegendes elektrisches Feld bewirkt wird. In einem lateralen DMOS-Transistor (LDMOS-Transistor) erstreckt sich die Drift-Zone in lateraler Richtung, zwischen der Kante des Steuergates und dem davon in lateraler Richtung beabstandeten Drain-Bereich.

LDMOS-Transistoren finden als Hochspannungsbauelemente Anwendung, in denen zwischen dem Drain-Bereich und dem Source-Bereich des LDMOS-Transistors Spannungen, so genannte Drain-Spannungen, von mehr als 100 Volt angelegt werden können. Daneben werden LDMOS-Transistoren auch als Hochfrequenz-Leistungsverstärker mit Drain-Spannungen im Bereich zwischen 10 Volt und 20 Volt als Betriebsspannung des Hochfrequenz-Leistungsverstärkers eingesetzt.

In der Drift-Zone des LDMOS-Transistors befindet sich ein oberflächennaher schwach dotierter Drain-Bereich, kurz LDD-Bereich (Low Doped Drain-Bereich), der sich zwischen der Kante des Steuergates und dem Drain-Bereich erstreckt und in dem die gleichen Ladungsträger wie im Drain-Bereich vorliegen.

Im LDD-Bereich und im Gebiet unterhalb des Steuergates, in dem ein hoch dotierter Bereich, kurz Wanne (engl. well), vorgesegen ist, beruht der Stromfluss jeweils auf unterschiedlichen Ladungsträgern. So sind im LDD-Bereich die Ladungsträger Elektronen, während sie in der Wanne Löcher sind oder umgekehrt. Daher bilden der LDD-Bereich und die Wanne eine Diode. Üblicherweise teilt sich die Wanne einen externen Anschluss mit dem Source-Bereich, sodass beide auf demselben Potenzial liegen. Der LDD-Bereich ist über den Drain-Bereich kontaktiert, so dass an ihrem drainseitigen Ende die Drainspannung anliegt. Liegt eine offene Schaltung der "Diode" vor, das heißt, es liegt weder am Steuergate noch am LDD-Bereich eine Spannung an (die Spannung des Steuergates wird, ebenso wie die Drainspannung, gegenüber dem Potenzial des Source-Bereichs gemessen), so fällt über der aus Wanne und LDD-Bereich bestehenden "Diode" keine Spannung ab, und es bildet sich am Übergang von der Wanne zum LDD-Bereich eine an Ladungsträgern verarmte Zone, die Verarmungszone. Über der Verarmungszone tritt ein Spannungsabfall auf, der dazu führt, dass die Verarmungszone auf den Bereich in der Nähe des Übergangs beschränkt bleibt. Wird nun eine Drain-Spannung angelegt, so wird der Spannungsabfall über der Veramungszone verstärkt. Auf Grund der hohen Drain-Spannungen in LDMOS-Transistoren treten in der Verarmungszone hohe. Spannungsabfälle auf. In der Verarmungszone entstehen durch thermische Anregung in geringen Mengen freie Ladungsträger. Werden die Spannungsabfälle zu hoch, so werden die thermisch angeregten freien Ladungsträger durch den Spannungsabfall in der Verarmungszone derart beschleunigt, dass sie durch die Kollision mit Atomen deren kovalente Bindungen aufbrechen können. Dies erzeugt neue freie Ladungsträger, die wiederum kovalente Bindungen aufbrechen können usw. Es kommt zum so genannten Lawinendurchbruch am Übergang.

Der beschriebene Lawinendurchbruch kann dazu führen, dass hochenergetische Ladungsträger, so genannte heiße Ladungsträger, in die Oxidschicht zwischen der Wanne und dem Steuergate (diese Oxidschicht nennt man Gateoxid) eindringen. Im Gateoxid werden diese Ladungsträger festgehalten, was mit der Zeit zu einer statischen Aufladung des Gateoxids führt, und so die Eigenschaften des LDMOS-Transistors verschlechtert. Ebenso dringen heiße Ladungsträger in eine über dem LDD-Bereich befindliche Oxidschicht oder Nitridschicht ein und werden dort festgehalten. Auch dies führt zu einer statischen Aufladung der entsprechenden Schicht. Eine solche Aufladung kann in ungünstigen Fällen zu einer starken Reduzierung oder vollständigen Unterdrückung des Stromflusses durch den DMOS-Transistor führen.

Außerdem bilden das Steuergate und die gateseitige Kante des LDD-Bereichs, zwischen denen sich ein Teil der Gateoxidschicht befindet, einen Kondensator. Bei hoher Drain-Spannung tritt über diesem Kondensator ein hoher Spannungsabfall auf, der dazu führen kann, dass durch diesen Spannungsabfall beschleunigte Ladungsträger die Oxidschicht durchbrechen. Man spricht dann vom Isolatorzusammenbruch (Insulator Breakdown).

Ein Ansatz, die oben geschilderten Nachteile zu beseitigen, besteht darin, die Ladungsträgerkonzentration in dem Teil des LDD-Bereichs, in dem ein Übergang zum hoch dotierten Bereich unterhalb des Steuergates vorliegt, soweit zu verringern, dass dieser Teil vollständig an Ladungsträgern verarmt, wenn am Steuergate keine Spannung anliegt und eine Drain-Spannung angelegt ist, die unterhalb der Drain-Durchbruchsspannung (BV_{DS}) liegt. Die Drain-Durchbruchsspannung ist diejenige Spannung, bei der sich die Verarmungszone am Übergang zwischen LDD-Bereich und Wanne bis zum Source-Bereich erstreckt. Die verringerte Ladungsträgerdichte des LDD-Bereichs führt jedoch zu einer Erhöhung des Widerstands des LDD-Bereichs im Einschaltzustand und somit zu einer Verringerung des durch den Drain-Bereich fließenden Stroms. Der Einschaltzustand des LDMOS-Transistors ist der Zustand, in dem unterhalb des Steuergates ein mit den Ladungsträgern, wie sie im Source- und im Drain-Bereich vorliegen, angereicherter Kanal, die sog. Inversionsschicht, gebildet ist. Die Inversionsschicht bildet sich, wenn am Steuergate eine Spannung, die sog. Gate-Spannung, mit einem bestimmten, für den Transistor kennzeichnenden Wert anliegt. Durch den erhöhten Widerstand im Einschaltzustand wird der Drain-Strom, also der durch den Drain-Bereich fließende Strom, verringert. Außerdem führt die geringe Dichte an freien Ladungsträgern auf Grund der verringerten Ladungsträgerkonzentration im LDD-Bereich zu einer erhöhten Empfindlichkeit gegenüber statischen Aufladungen der über dem LDD-Bereich befindlichen Oxid- oder Nitridschicht.

Der Stand der Technik geht aus den Anmeldungen DE 100 04 387, DE 100 63 135 und WO 01/75979 hervor. Im Falle der Anwendung eines hochohmigen Halbleitersubstrates haben die bisher bekannten LDMOS-Konstruktionen einschließlich der in o.g. Erfindung beschriebenen verbesserten Konstruktion den Nachteil einer auch bei kleinen Drainspannungen (z.b.Vg = 0-0,1V) sehr geringen Kapazität zwischen der unverarmten LDD-Zone an der Oberfläche des Driftraumes und dem Substrat, insbesondere im schwachdotierten Gebiet zwischen dem die Schwellspannung des Steuergates bestimmenden Wellbereich und dem hochdotierten Draingebiet. Um trotz dieser kleinen Kapazität entsprechend der obengenannten Anmeldungen im abgeschalteten Zustand (bei der Gatespannung Vg = 0) und einer Drainspannung deutlich unterhalb der Draindurchbruchspannung BV_{DS} die totale Verarmung eines möglichst großen Teiles des Driftraumes an freien Ladungsträgern und damit eine niedrige Drain/Gate-Kapazität und eine möglichst hohe Draindurchbruchspannung bei nicht zu hoher Feldstärke am dünnen Gateisolator des Steuergates zu sichern, muß die Zahl der freien Ladungsträger im LDD-Bereich und damit auch die Leitfähigkeit im "on" Zustand durch eine hinreichend geringe Implantationsdosis im LDD-Bereich entsprechend begrenzt werden. Diese geringe Implantationsdosis bewirkt außer der begrenzten Leitfähigkeit (hoher "on"-Widerstand Ron und schlechtes Stromsättigungsverhalten) auch eine unerwünscht hohe Empfindlichkeit der LDMOS-Parameter (z.B.Ron, Ft, Fmax) gegenüber statischen Aufladungen der Halbleiteroberfläche, z. B. bei hoher Drainspannung durch die Injektion heißer Ladungsträger aus dem LDD-Bereich in die elektronischen Haftstellen an der(den) Grenzfläche(n) einer Passivierungsschicht. Eine solche Aufladung kann in ungünstigen Fällen zu einer starken Reduzierung oder totalen Abschnürung des Drainstromes bei kleinen Drainspannungen führen.

Weiterhin ist aus der EP 0 295 391 ein LDMOS-Transistor mit einem Source-Bereich, einem Drain-Bereich, einem Steuergate sowie einer sich zwischen dem Drain∼Bereich und dem Steuergate erstreckenden Drift-Zone bekannt. In der Drift-Zone ist ein LDD-Bereich desselben Leitfähigkeitstyps wie der des Drain-Bereichs gebildet, und über dem LDD-Bereich ist eine Deckschicht vorgesehen, die den dem Leitfähigkeitstyp des LDD-Bereichs entgegengesetzten Leitfähigkeitstyp aufweist.

Aufgabe der vorliegenden Erfindung ist es, einen verbesserten LDMOS-Transistor zur Verfügung zu stellen.

Ein Ziel der vorliegenden Erfindung ist es außerdem, die Leitfähigkeit des LLD-Bereiches bei kleinen Drainspannungen durch Vergrößerung der Implantationsdosis zu erhöhen und damit Ron, das Sättigungsverhalten des Drainstromes und die Hochfrequenzeigenschaften der LDMOS Transistoren zu verbessern, ohne die Draindurchbruchspanung zu verringern.

Ein weiteres Ziel der Erfindung ist die Verringerung der durch die Aufladung oder Umladung von Traps an der Oberfläche des Driftraumes infolge einer Injektion heißer Ladungsträger oder anderer Effekte auftretenden Instabilitäten von Ron und weiterer, mit Ron gekoppelter LDMOS-Parameter.

Eine weitere Aufgabe der vorliegenden Erfindung ist es, ein einfaches Verfahren zur Herstellung eines verbesserten LDMOS-Transistor zur Verfügung zu stellen.

Diese Aufgaben werden durch einen LDMOS-Transistor nach Anspruch 1 bzw. ein Verfahren nach Anspruch 7 gelöst. Weitere Ausgestaltungen des erfindungsgemäßen LDMOS-Transistors sind in den Ansprüchen 2 bis 6 angegeben, weitere Ausgestaltungen des erfindungsgemäßen Verfahrens in den Ansprüchen 8 bis 18.

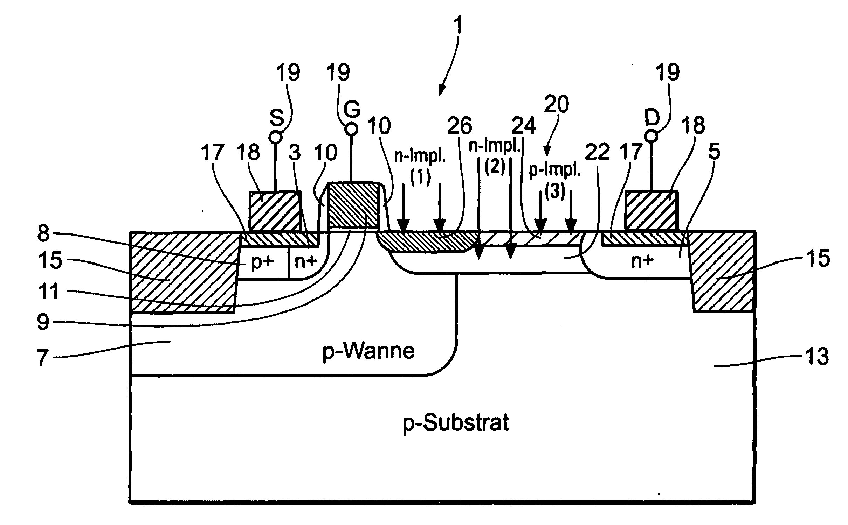

Die o.g. Zielstellung wird durch die Einführung einer LDD Doppelimplantation erreicht, bei welcher neben der Implantation eines LDD Gebietes vom Leitungstyp der hochdotierten S/D-Gebiete (in Fig.1 n-Implantation 1 und 2 genannt) zusätzlich eine zweite flachere Ionenimplantation mit geringerer Dosis als erstere vom entgegengesetzten Leitungstyp (in Fig. 1 p-Implantation genannt) erfolgt. Dosis und Energie dieser zusätzlichen Implantation werden so mit der ersten LDD Implantation vom Leitungstyp der S/D-Gebiete 3, 5 abgestimmt, daß bei einer Drainspannung, die deutlich kleiner ist, als die mittlere Betriebsspannung des LDMOS-Transistors, die zweite flachere Implantationsschicht zusammen mit dem an das Gate angrenzenden, über dem Wellbereich 7 liegenden Teil des LDD-Gebietes 22, 26 vom Leitungstyp der S/D-Gebiete 3, 5 weitgehend von freien Ladungsträgern verarmt. Damit kann die Restleitfähigkeit der zweiten flacheren Implantationsschicht im Hinblick auf die Hochfrequenzeigenschaften vernachlässigt werden. Relevante Verschiebungsströme treten im Arbeitspunkt des LDMOS-Transistors demzufolge im LDD-Bereich nur zwischen den den Drainstrom tragenden Ladungsträgern und dem Substrat 13 bzw. zu dem die Schwellspannung des Transistors bestimmenden, den Driftraum überlappenden Wellbereich 7 auf. Bei richtiger Dimensionierung der erfindungsgemäßen Zusatzimplantation werden daher im Arbeitspunkt weder die Drain/Gate Kapazität noch die Drain/Substratkapazität erhöht. Andererseits ermöglicht die o.g. Zusatzimplantation eine Erhöhung der Implantationsdosis und damit der Leitfähigkeit des LDD-Gebietes 22, 26 bei Vd = 0V, ohne daß sich die zur totalen Verarmung desselben erforderliche Drainspannung erhöht. Daraus resultiert eine Verringerung von Ron und eine Verbesserung der Grenzfrequenz Ft.

Ein weiterer wesentlicher Vorteil der erfindungsgemäßen Zusatzimplantation ist der Aufbau einer Potentialbarriere bezüglich heißer Ladungsträger zwischen dem Ladungsträgerkanal im LDD-Bereich 22, 26 und der darüberliegenden Halbleiteroberfläche. Dadurch verlieren die im Driftfeld aufgeheizten Ladungsträger entsprechen der Barrierenhöhe kinetische Energie (1-2 eV) und können nur noch zu einem geringen Anteil in das Leitungsband des Passivierungsoxides über dem Driftraum gelangen, was die Kurzzeit-und Langzeitstabilität der LDMOS Transistoren verbessert.

Um die beim Betrieb des RFLDMOST durch thermische Generation oder durch Ladungsträgermultiplikation erzeugten Ladungsträger vom Typ der Inversionszone aus derselben zum Wellbereich 7 bzw. zum Substrat 13 abzuführen, kann es insbesondere bei einer relativ hohen Nettodotierung der Inversionszone 24 zweckmäßig sein, dieselbe an der Gatekante im Randbereich des Driftraumes 20 auszusparen. Dadurch wird einer möglichen Instabilität des Oberflächenpotentials durch eine Variation der Ladungsträgerkonzentration in der Inversionsschicht vorgebeugt.

Durch das Vorsehen einer Deckschicht, mit dem entgegengesetzten Leitfähigkeitstyp wie der des darunter befindlichen LDD-Bereichs wird erreicht, dass die Dotierung des LDD-Bereichs erhöht werden kann, ohne dass die Verarmung der Ladungsträger im Bereich des Überganges zwischen dem schwach dotierten LDD-Bereich und der Wanne wesentlich beeinträchtigt wird. Außerdem stellt die Deckschicht eine Potenzialbarriere für heiße Ladungsträger dar, die der statischen Aufladung der Isolatorschicht auf Grund injizierter heißer Ladungsträger entgegenwirkt.

Mit zwei zusätzlichen Implantationsschritten lässt sich das Verfahren zur Herstellung des erfindungsgemäßen LDMOS-Transistors in einen Standard-CMOS-Prozess integrieren.

Anhand der beiliegenden Zeichnung wird nun ein Ausführungsbeispiel der Erfindung im Detail beschrieben.

In der Figur ist ein erfindungsgemäßer LDMOS-Transistor 1 im vertikalen Schnitt dargestellt. Zwischen einem n⁺-dotierten Source-Bereich 3 und einem ebenfalls n⁺-dotierten Drain-Bereich 5 befindet sich ein p⁺-dotierter Bereich, der Teil einer p⁺-dotierten Wanne 7, kurz p⁺-Wanne (engl. p⁺-well), ist. Über dem p⁺-dotierten Bereich befindet sich das Steuergate 9, das von p⁺-dotierten Bereich durch eine Oxidschicht, das Gateoxid 11 getrennt ist. Der gesamte LDMOS-Transistor ist in einer p⁻-dotierten epitaktischen Siliziumschicht 13 über einem hochohmigen Substrat gebildet und durch oxidgefüllte Gräben, sog. Trench-Isolierungen 15, lateral begrenzt. Im vorliegenden Fall handelt es sich um flache Trench-Isolierungen (sog. Shallow Trenches).

Die Bezeichnungen n-dotiert und p-dotiert bedeuten, dass die Ladungsträger Elektronen bzw. Löcher sind. Im Halbleiter existieren zwei verschiedene Leitfähigkeitstypen. Materialien mit Elektronen als Ladungsträger nennt man n-leitend, solche mit Löchern als Ladungsträger p-leitend. Im Silizium (Si) liegen beide Sorten von Ladungsträgern in gleicher Konzentration vor. Durch das Einbringen von Fremdatomen, sog. Dotierstoffen, lässt sich die Ladungsträgerkonzentration erhöhen. Dieser Vorgang heißt Dotierung. Eine n-Dotierung liegt vor, wenn der eingebrachte Dotierstoff ein n-Dotierstoff (Donator) ist, also einer, der zu einer Zunahme der Konzentration an Elektronen als Ladungsträger führt. Das Material ist dann n-leitend bzw. n-dotiert. Als n-Dotierstoff werden Phosphor (P), Arsen (AS) und Antimon (Sb) verwendet. Andererseits liegt eine p-Dotierung vor, wenn der eingebrachte Dotierstoff ein p-Dotierstoff (Akzeptor) ist, also einer, der zu einer Zunahme der Konzentration an Löchern als Ladungsträger führt. Das Material ist dann p-leitend bzw. p-dotiert. Als p-Dotierstoff findet Bor (B) Verwendung. Ist die Zunahme der Konzentration an Elektronen/Löchern nach der Dotierung sehr groß oder sehr gering, liegt ein hoch dotiertes (n⁺/p⁺-dotiertes) Material bzw. ein schwach dotiertes (n-/p⁻-dotiertes) Material vor.

Zur Kontaktierung des Source-Bereichs 3, des Drain-Bereichs 5 sowie des Steuergates 9 ist über diesen Bereichen bzw. dem Steuergate 9 jeweils eine Silizidschicht 17 abgeschieden, die über ein mit Metall 18 gefülltes Kontaktloch in einer Isolatorschicht (nicht dargestellt) mit einem externen Anschluss 19 verbunden ist. Die Silizidschicht 17, das mit Metall 18 gefüllte Kontaktloch sowie der externer Anschluss 19, welche die Kontakte für den Source-Bereich 3 darstellen, sind außerdem als Kontakt für die p-Wanne 7 vorgesehen. Die p-Wanne 7 steht jedoch mit der Silizidschicht 17 nicht in direktem Kontakt, sondern lediglich über einen p⁺-dotierten Anschlussbereich 8.

Typisch für einen LDMOS-Transistor ist die Drift-Zone 20, die sich vom Drain-Bereich 5 ausgehend bis zur Kante des Steuergates 9 erstreckt. Im Ausführungsbeispiel überlappt ein Teil der p⁺-Wanne 7 die Drift-Zone 20.

In der Drift-Zone 20 ist ein erster, schwach n-dotierter Drain-Bereich oder LDD-Bereich 22, wobei LDD für Low Doped Drain steht, gebildet. Der erste LDD-Bereich 22 erstreckt sich vom n⁺-dotierten Drain-Bereich 5 bis zur Kante des drainseitigen Gate-Spacers 10, er erreicht die Kante des Steuergates 9 (Gate-Kante) daher nicht ganz. Seine Tiefe ist geringer ist als die des Drain-Bereichs 5. Erfindungsgemäß befindet sich über dem ersten LDD-Bereich 22 eine flache, hoch p-dotierte (p⁺-dotierte) Deckschicht 24 mit einer Dotierstoffkonzentration von 1x10¹⁸ cm⁻³. Die auf die Fläche bezogene Dotierstoffkonzentration in der Deckschicht 24 beträgt jedoch max. 8x10¹² cm⁻², vorzugsweise 2x10¹² cm⁻². Mit der Deckschicht 24 kann die Dotierstoffkonzentration des ersten LDD-Bereichs 22 gegenüber der in den bekannten LDMOS-Transistoren erhöht werden. Die auf die Fläche bezogene Dotierstoffkonzentration im ersten LDD-Bereich 22 überschreitet 1x10¹³ cm⁻² jedoch nicht.

Im Ausführungsbeispiel ist an die Gate-Kante angrenzend über dem ersten LDD-Bereich 22 noch ein gegenüber dem ersten LDD-Bereich 22 etwas höher n-dotierter, zweiter LDD-Bereich 26 gebildet. Mit seinem gateseitigen Ende ragt der zweite LDD-Bereich 26 daher um die Breite des Gate-Spacers 10 über den ersten LDD-Bereich 22 hinaus. Da sich nur der zweite LDD-Bereich 26 bis zur Gate-Kante erstreckt, stellt er das gateseitige Drain-Ende dar. Der zweite LDD-Bereich 26 erstreckt sich in lateraler Richtung von der Gate-Kante ausgehend in Richtung auf den Drain-Bereich 5 ein wenig über den Bereich der p-Wanne 7 hinaus. Dort, wo der zweite LDD-Bereich 26 vorliegt, ersetzt dieser die p-dotierte Deckschicht 24. Diese Deckschicht 24 erstreckt sich daher lateral zwischen dem Drain-Bereich 5 und dem zweiten LDD-Bereich 26. Die auf die Fläche bezogene Konzentration an n-Dotierstoff im zweiten LDD-Bereich 26 ist geringer als die der p⁺-Wanne, sie beträgt maximal 5x10¹³ cm⁻².

Die gegenüber der p⁺-Wanne geringere flächenbezogene Dotierstoffkonzentration des ersten LDD-Bereichs 22 und des zweiten LDD-Bereichs 26 bewirkt, dass sich die Verarmungszone am pn-Übergang zwischen der p-Wanne 7 und dem ersten LDD-Bereich 22 bzw. dem zweiten LDD-Bereich 26 weiter in den ersten LDD-Bereich 22 hinein erstreckt, als in die p-Wanne 7, wenn am Steuergate keine Spannung und am Drain-Bereich 5 eine Spannung, die kleiner ist als die Drain-Durchbruchsspannung BV_{DS}, anliegt. Die Dotierstoffkonzentration des ersten LDD-Bereichs 22 ist dabei so gewählt, dass dieser zumindest in seinem Überlappbereich mit der p⁺-Wanne 7 vollständig an Ladungsträgern verarmt ist. Dadurch fällt die Drain-Spannung über eine relativ lange Strecke ab, sodass das Potenzial in der Nähe des gateseitigen Endes des ersten LDD-Bereichs 22 verringert ist. Gleiches gilt für den zweiten LDD-Bereich 26.

Die Deckschicht 24 unterstützt die Ausdehnung der Verarmungszone in den ersten LDD-Bereich 22 hinein und ermöglicht somit die gegenüber den bekannten LDMOS-Transistoren erhöhte flächenbezogene Dotierung des ersten LDD-Bereichs 22. Deshalb kann bei vorhandener Deckschicht 24 die Leitfähigkeit des ersten LDD-Bereichs 22 erhöht werden, ohne dass gleichzeitig das Potenzial am gateseitigen Ende des ersten LDD-Bereichs 22 erhöht wird. Außerdem wird die Empfindlichkeit des ersten LDD-Bereichs 22 auf statische Aufladungen der die Drift-Zone 20 bedeckenden Isolatorschicht durch die erhöhte Ladungsträgerkonzentration verringert. Gleichzeitig stellt die p-dotierte Deckschicht 24 eine Potenzialbarriere für hochenergetische Elektronen (heiße Ladungsträger) im ersten LDD-Bereich 22 dar, wodurch das Eindringen der hochenergetischen Elektronen in die Isolatorschicht und somit deren statische Aufladung unterdrückt wird.

Die Auswirkungen der Deckschicht 24 hängen von ihrer Tiefe sowie von ihrer Dotierstoffkonzentration ab. Vorzugsweise ist die Tiefe und die Dotierstoffkonzentration in der Deckschicht 24 so gewählt, dass der erste LDD-Bereich 22 bei möglichst hoher Leitfähigkeit zumindest in dem Bereich, in dem er mit der p-Wanne 7 überlappt, bereits bei einer Drain-Spannung von 2 bis 2,5 Volt vollständig an Leitungsträgern verarmt ist.

Das beschriebene Ausführungsbeispiel stellt einen n-Kanal-Transistor dar. In einem solchen werden, wenn an das Steuergate 9 eine einen bestimmten Wert überschreitende positive Spannung angelegt wird, die Löcher als Ladungsträger in der p-Wanne 7 vom gateseitigen Ende der p-Wanne 7 weggedrückt. Gleichzeitig werden von der positiven Spannung Elektronen aus dem Source-Bereich 3 und dem Drain-Bereich 5 (im LDMOS-Transistor aus dem LDD-Bereich bzw. den LDD-Bereichen) in die p-Wanne gezogen, wodurch unterhalb des Steuergates 9 lokal ein Überschuss an Elektronen als Ladungsträger entsteht, der so genannte n-Kanal, auch Inversionsschicht genannt. Ein p-Kanal-Transistor funktioniert nach dem gleichen Prinzip, jedoch sind Elektronen und Löcher als Ladungsträger vertauscht. Daraus folgt, dass die Dotierungen im p-Kanal-Transistor gegenüber denen in einem n-Kanal-Transistor entgegengesetzt sind. Unter Berücksichtigung der entgegengesetzten Dotierung ist die im Ausführungsbeispiel beschriebene Erfindung auch auf einen p-Kanal-Transistor anwendbar.

Im Folgenden wird ein Herstellungsverfahren für den erfindungsgemäßen n-Kanal-LDMOS-Transistor 1 beschrieben, wobei nur auf diejenigen Prozesschritte eingegangen wird, die der Herstellung des n-Kanal-LDMOS-Transistors dienen.

Im ersten Schritt wird auf einem hochohmigen Siliziumsubstrat eine epitaktische, p⁻-dotierte Schicht 13 abgeschieden. Danach werden in einem üblichen CMOS-Prozessschritt (CMOS steht für Complementary Metal-Oxid Semiconductor und bedeutet, dass ein n-Kanal-Transistor und ein p-Kanal-Transistor in einem gemeinsamen Substrat hergestellt werden) die Gräben für die Trench-Isolierungen 15 selektiv geätzt und anschließend die Gräben mit Oxid gefüllt, um die aktiven Bereiche der verschiedenen Transistoren gegeneinander abzugrenzen.

Im nächsten, ebenfalls üblichen Schritt wird auf einen Teil des aktiven Bereichs des LDMOS-Transistors 1 eine Nitridmaske abgeschieden. Die Maske bedeckt den für die Drift-Zone 20 vorgesehenen Bereich fast vollständig. Lediglich derjenige Teil, der an das noch zu bildende Steuergate 9 angrenzt, bleibt unmaskiert. Danach wird Bor oder BF₂ in die p⁻-dotierte epitaktische Schicht 13 ionenimplantiert, sodass sich im unmaskierten Bereich die p-Wanne 7 (p-Well) bildet. Die p-Wanne 7 erstreckt sich daher ein wenig in die Drift-Zone 20 hinein.

Anschließend wird ohne Maske das Gateoxid 11 auf die gesamte Oberfläche des aktiven Bereichs des LDMOS-Transistors abgeschieden. Danach wird über dem Gateoxid 11 eine polykristalline oder amorphe Siliziumschicht abgeschieden, die anschließend unter Verwendung einer Maske geätzt wird, sodass das Steuergate 9 auf der Oxidschicht 11 zurückbleibt. Auch dies ist ein Standard-CMOS-Schritt

Im nächsten, gegenüber dem Standard-CMOS-Prozess zusätzlichen Schritt wird eine Nitridmaske aufgebracht, welche denjenigen Teil der Drift-Zone 20, in dem die p-Wanne 7 gebildet ist, und einen kleinen, an die p-Wanne 7 angrenzenden Teil der Drift-Zone 20 unbedeckt lässt. Dann wird eine Ionenimplantation mit Phosphor durchgeführt, um den flachen zweiten LDD-Bereich 26 zu erzeugen. Die Implantationsdosis beträgt höchstens 5x10¹³ cm⁻², vorzugsweise 1x10¹³ cm⁻².

Nach der Implantation von Phosphor wird die Nitridmaske entfernt, und es werden in üblicher Weise die Gate-Spacer 10 aus Nitrid an den Seitenwänden des Steuergates 9 abgeschieden. Dann wird das Gateoxid 11 weggeätzt, so das es lediglich unter dem Steuergate und den Gate-Spacern 10 erhalten bleibt.

Anschließend wird in einem Standard-CMOS-Schritt eine neue Nitridmaske abgeschieden, welche die Bereiche, in denen Source und Drain gebildet werden sollen, unbedeckt lässt. Mittels einer Ionenimplantation unter Verwendung von Phosphor werden dann der Source-Bereich 3 und der Drain-Bereich 5 gebildet.

Danach wird die Nitridmaske entfernt und eine neue, übliche Nitridmaske aufgebracht, die denjenigen Bereich unbedeckt lässt, in dem der Anschlussbereich 8 für die p-Wanne 7 entstehen soll. Mittels einer Ionenimplantation unter Verwendung von Bor oder BF₂ wird im unmaskierten Abschnitt des aktiven Bereichs des LDMOS-Transistors der Anschlussbereich 8 für die p-Wanne 7 gebildet.

Nach der Entfernung der Maske schließt sich eine gegenüber dem Standard-CMOS-Prozess zusätzliche Ionenimplantation von Phosphor ohne Maskierung an, um den ersten LDD-Bereich 22 zu bilden. Dabei beträgt die Implantationsdosis höchstens 1x10¹³ cm⁻², vorzugsweise 5x10¹² cm⁻². Es folgt eine weitere unmaskierte Ionenimplantation, diesmal unter Verwendung von Bor oder BF₂, um die Deckschicht 24 zu bilden. Die Implantationsdosis beträgt höchstens 8x10¹² cm⁻², vorzugsweise 2x10¹² cm⁻².

Vorzugsweise wird die Energie und die Dosis der Implantierung für die Deckschicht 24 so gewählt, dass der erste LDD-Bereich 22 bei möglichst hoher Leitfähigkeit zumindest in dem Bereich, in welchem er mit der p-Wanne 7 überlappt, bereits bei einer Drain-Spannung von 2 bis 2,5 Volt vollständig an Leitungsträgern verarmt.

Im nächsten Schritt wird in üblicher Weise eine Silizierung der Oberflächen des Source-Bereichs 3, des Drain-Bereichs 5, des Anschlussbereichs 8 sowie des Steuergates 9 vorgenommen. Die Silizierung erfolgt unter Verwendung üblicher Silizidblocker, z. B. einer strukturierten Nitridschicht, zur Verhinderung der Bildung von Silizid auf den Oberflächenabschnitten, auf denen keine Silizierung stattfinden soll.

Schließlich wird der LDMOS-Transistor unter Verwendung üblicher CMOS-Prozessschritte, welche das Bilden einer dicken Oxidschicht, das Ätzen von Kontaktlöchern, das Füllen der Kontaktlöcher mit Metall sowie das Abscheiden von Leiterbahnen umfassen, fertig gestellt.

## Patentansprüche

1. LDMOS-Transistor mit einem Source-Bereich (3), einem Drain-Bereich (5), einem Steuergate (9) sowie einer sich zwischen dem Drain-Bereich (5) und dem Steuergate (9) erstreckenden Drift-Zone (20), wobei in der Drift-Zone (20) ein erster LDD-Bereich (22) desselben Leitfähigkeitstyps wie der des Drain-Bereichs (5) gebildet ist und über dem ersten LDD-Bereich (22) eine Deckschicht (24) vorgesehen ist, die den dem Leitfähigkeitstyp des ersten LDD-Bereichs (22) entgegengesetzten Leitfähigkeitstyp aufweist, **dadurch gekennzeichnet, dass** die Deckschicht (24) am gateseitigen Ende des ersten LDD-Bereichs (22) durch einen im Vergleich mit dem ersten LDD-Bereich (22) mit höherer Dotierung versehenen zweiten LDD-Bereich (26) desselben Leitfähigkeitstyps wie der des Drain-Bereichs (5) ersetzt ist.

2. LDMOS-Transistor nach Anspruch 1, **dadurch gekennzeichnet, dass** die auf die Fläche bezogene Dotierstoffkonzentration in der ersten LDD-Schicht (22) einen Wert von 1x10¹³ cm⁻² nicht übersteigt und die auf die Fläche bezogene Dotierstoffkonzentration in der Deckschicht (24) einen Wert von 8x10¹² cm⁻² nicht übersteigt.

3. LDMOS-Transistor nach einem der Ansprüche 1 bis 2, **dadurch gekennzeichnet, dass** eine hoch dotierte p-Wanne (7) vorgesehen ist, die sich unterhalb des Source-Bereichs (3), unterhalb des Steuergates (9) sowie unterhalb eines Teils des ersten LDD-Bereichs (22) erstreckt.

4. LDMOS-Transistor nach Anspruch 3, **dadurch gekennzeichnet, dass** die p-Wanne (7) mit dem größten Teil desjenigen Abschnitts des ersten LDD-Bereiches (22), in dem der zweite LDD-Bereich (26) gebildet ist, überlappt.

5. LDMOS-Transistor nach einem der vorangehenden Ansprüche, **dadurch gekennzeichnet, dass** die Dotierstoffkonzentrationen im ersten LDD-Bereich (22), in der Schicht (24) sowie im zweiten LDD-Bereich (26) derart gewählt sind, dass der erste LDD-Bereich (22) und der zweite LDD-Bereich (26) vollständig an Ladungsträgern verarmt ist, wenn an Steuergate (9) keine Spannung angelegt ist und eine Drain-Spannung angelegt ist, die kleiner ist als Durchbruchsspannung BV_{DS} des Drain-Bereichs (5).

6. LDMOS-Transistor nach Anspruch 5, **dadurch gekennzeichnet, dass** der erste LDD-Bereich (22) und der zweite LDD-Bereich (26) zumindest im Bereich des Überlapps mit der p-Wanne (7) vollständig an Ladungsträgern verarmt ist, wenn am Steuergate keine Spannung angelegt ist und eine Drain-Spannung von 2 bis 2,5 Volt angelegt ist.

7. Verfahren zur Herstellung eines CMOS-kompatiblen LDMOS-Transistors, bei dem im Bereich eines zwischen einem Drain-Bereich (5) und einem Steuergate (9) befindlichen Driftraumes (20) oberhalb eines LDD-Bereiches (22, 26) eine im Vergleich zur Eindringtiefe von Source/Drain-Bereichen (3, 5) flache Dotierungszone (24) als Deckschicht vom umgekehrten Leitungstyp des LDD-Bereiches (22, 26) angeordnet wird, wobei die Deckschicht in einem in der Verfahrensabfolge zweiten von zwei gegenüber einem Standard-CMOS-Prozess zusätzlichen Implantationsschritten gebildet wird, **dadurch gekennzeichnet, dass** in einem in der Verfahrensabfolge ersten der zwei zusätzlichen Implantationsschritte am gateseitigen Ende des ersten LDD-Bereiches (22) ein zweiter LDD-Bereich (26) desselben Leitfähigkeitstyps wie der des Drain-Bereichs (5) und mit im Vergleich zum ersten LDD-Bereich (22) höherer Dotierung gebildet wird.

8. Verfahren nach Anspruch 7, **dadurch gekennzeichnet, dass** der erste zusätzliche Implantationsschritt nach der Bildung des Steuergates (9) und vor der Bildung der Gate-Spacer (10) erfolgt und der zweite Implantationsschritt nach der Bildung der Gate-Spacer (10) erfolgt.

9. Verfahren nach Anspruch 8, **dadurch gekennzeichnet, dass** im ersten zusätzlichen Implantationsschritt zur Bildung des zweiten LDD-Bereiches (26) eine Maske verwendet wird, deren Fenster sich von der Gate-Kante in Richtung auf dem Drain-Bereich (5) erstreckt, wobei ein kleiner Abschnitt des Fensters über den Bereich, in dem die p-Wanne (7) gebildet ist, hinausgeht.

10. Verfahren nach einem der Ansprüche 7 bis 9, **dadurch gekennzeichnet, dass** der zweite zusätzliche Implantationsschritt ohne Maske durchgeführt wird.

11. Verfahren nach einem der Ansprüche 7 bis 10, **dadurch gekennzeichnet, dass** die Erzeugung der Deckschicht (24) mit einer Energie und einer Dosis erfolgt, die so gewählt sind, dass der erste LDD-Bereich (22) bei möglichst hoher Leitfähigkeit zumindest in dem Bereich, in welchem er mit der p-Wanne (7) überlappt, bereits bei einer Drain-Spannung von 2 bis 2,5 Volt vollständig an Leitungsträgern verarmt.

12. Verfahren nach Anspruch 7, bei dem in der Deckschicht eine auf die Fläche bezogene Nettodotierung eingestellt wird, die geringer ist, als die Nettodotierung des LDD-Bereiches (22, 26) und die eine Nettodotierung von 8E12 At/cm⁻² nicht überschreitet.

13. Verfahren Anspruch 7, **dadurch gekennzeichnet, daß** der LDMOS-Transistor gemeinsam mit Standardtransistoren hergestellt wird, wobei eine Lateralisolation (15), ein Gateoxid (11), das Steuergate (9) und hochdotierte Source/Drain-Bereiche (3, 5) des LDMOS-Transistors in einem CMOS-Standardprozess erzeugt werden und die die Lateralisolation, das Gateoxid, das Steuergate und die hochdotierten Source/Drain-Bereiche entsprechenden Komponenten der Standardtransistoren gleichen.

14. Verfahren nach Anspruch 13, bei dem eine in den Driftraum (20) hineinreichende, die Schwellspannung und das Kurzkanalverhalten des Transistors beeinflussende Dotierungszone (7) vom entgegengesetzten Leitungstyp, die nachfolgend als Wannenbereich bezeichnet wird, gemeinsam mit entsprechenden Wannenbereichen der Standard-transistoren hergestellt wird, wobei der höher dotierte, unmittelbar an das Steuergate anschließende Bereich (26) des zweiten LDD-Bereiches zunächst durch eine gesonderte Lackmaske mittels einer separaten Ionenimplantation oder mehrerer separater lonenimplantationen vordotiert wird und danach zur Komplettierung der Dotierung des LDD-Bereiches (22, 26) und der Deckschicht (24) im Driftraum zwei oder mehrere weitere maskenlose Ionenimplantationen durchgeführt werden.

15. Verfahren nach Anspruch 13, **dadurch gekennzeichnet, daß** in einem aktiven Bereich des LDMOS-Transistors eine standardmäßige, vor der Herstellung der Polygates (9) erfolgende Wannendotierung durch eine entsprechende Gestaltung einer dazugehörigen Lackmaske ausgespart wird und daß der in den Driftraum (20) hineinragende Wannenbereich durch eine gesonderte Lackmaske zusammen mit dem höher dotierten, unmittelbar an das Steuergate anschließenden Bereich des LDD-Gebietes (22, 26) durch eine Folge von Ionenimplantationen unterschiedlichen Leitungstyps nach der Strukturierung von Polygates dotiert wird und daß danach zwei oder mehrere weitere maskenlose Ionenimplantationen die Dotierung des ersten LDD-Bereiches und der Deckschicht (24) im Driftraum komplettieren.

16. Verfahren nach Anspruch 15, **dadurch gekennzeichnet, daß** der in den Driftraum (20) hineinragende Wannenbereich (7) durch die Kombination einer standardmäßigen Haloimplantation mit einer zusätzlichen Implantation größerer Eindringtiefe von Dotanden des gleichen Leitungstyps durch eine gesonderte Lackmaske entsteht, wobei durch die gleiche Lackmaske die Dotierung des unmittelbar an das Steuergate (9) anschließenden zweiten LDD-Bereiches (26) erfolgt.

17. Verfahren nach Anspruch 15 oder 16, **dadurch gekennzeichnet, daß** durch eine Abstimmung von Maskenhöhe, Implantationswinkel und Energie bei der zusätzlichen Wannenimplantation durch eine gesonderte Lackmaske eine ausreichende Abschattung der Wannenimplantation in Nähe einer drainseitigen Maskenkante erreicht wird, so daß eine drainseitige Überlappung des höherdotierten LDD-Gebietes (26) über den Wannenbereich (7) gesichert wird und eine den "on" Widerstand erhöhende Potentialbarriere im Driftraum vermieden wird.

18. Verfahren nach Anspruch 15 oder 16, **dadurch gekennzeichnet, daß** eine Potentialbarriere **dadurch** vermieden wird, daß nach der zusätzlichen Wannenimplantation durch eine gesonderte Lackmaske von der Implantation des höherdotierten zweiten LDD-Bereiches (26) ein isotroper Lackabtrag mit einer entsprechenden Lateralverschiebung einer Lackkante erfolgt.

## Claims

1. LDMOS transistor having a source region (3), a drain region (5), a control gate (9) and a drift zone (20) extending between the drain region (5) and the control gate (9), wherein in the drift zone (20) a first LDD region (22) of the same conductivity type as that of the drain region (5) is formed and over the first LDD region (22) is provided a covering layer (24) which has the opposite conductivity type to that of the first LDD region (22), **characterised in that** the covering layer (24) at the gate end of the first LDD region (22) is replaced by a second LDD region (26) of the same conductivity type as that of the drain region (5) and provided with higher doping compared with the first LDD region (22).

2. LDMOS transistor according to claim 1, **characterised in that** the concentration of dopant in the first LDD layer (22) in relation to the surface area does not exceed a value of 1x10¹³ cm⁻² and the concentration of dopant in the covering layer (24) in relation to the surface area does not exceed a value of 8x10¹² cm⁻².

3. LDMOS transistor according to one of claims 1 to 2, **characterised in that** a highly doped p-well (7) is provided which extends underneath the source region (3), underneath the control gate (9) and underneath part of the first LDD region (22).

4. LDMOS transistor according to claim 3, **characterised in that** the p-well (7) overlaps with the majority of that part of the first LDD region (22) in which the second LDD region (26) is formed.

5. LDMOS transistor according to one of the preceding claims, **characterised in that** the dopant concentrations in the first LDD region (22), in the layer (24) and in the second LDD region (26) are such that the first LDD region (22) and the second LDD region (26) is totally depleted in charge carriers if no voltage is applied to the control gate and a drain voltage is applied which is less than the breakthrough voltage BV_{DS} of the drain region (5).

6. LDMOS transistor according to claim 5, **characterised in that** the first LDD region (22) and the second LDD region (26) are totally depleted in charge carriers at least in the region of the overlap with the p-well (7) if no voltage is applied to the control gate and a drain voltage of 2 to 2.5 volts is applied.

7. Method of producing a CMOS-compatible LDMOS transistor, wherein in the region of a drift chamber (20) located between a drain region (5) and a control gate (9) above an LDD region (22, 26), a doping zone (24) is provided which is flat by comparison with the depth of penetration of source/drain regions (3, 5), as a covering layer of the opposite conductivity type compared with the LDD region (22, 26), wherein the covering layer is formed in a second of two implanting steps, in the order of the process, which are additional compared with a standard CMOS process, **characterised in that** in a first of the two additional implanting steps, in the order of the process, a second LDD region (26) of the same conductivity type as that of the drain region (5) and with higher doping compared with the first LDD region (22) is formed at the gate end of the first LDD region (22).

8. Method according to claim 7, **characterised in that** the first additional implantation step takes place after the formation of the control gate (9) and before the formation of the gate spacers (10) and the second implantation step takes place after the formation of the gate spacers (10).

9. Method according to claim 8, **characterised in that** in the first additional implantation step, a mask is used to form the second LDD region (26), the window of said mask extending from the gate edge towards the drain region (5), while a small portion of the window extends over the region in which the p-well (7) is formed.

10. Method according to one of claims 7 to 9, **characterised in that** the second additional implantation step is carried out without a mask.

11. Method according to one of claims 7 to 10, **characterised in that** the production of the covering layer (24) is carried out with an energy and a dose that are selected such that the first LDD region (22), at the highest possible conductivity, is totally depleted in conductive carriers even at a drain voltage of 2 to 2.5 volts, at least in the region in which it overlaps with the p-well (7).

12. Method according to claim 7, wherein a net doping, in relation to the surface area, is selected in the covering layer which is less than the net doping of the LDD region (22, 26) and which does not exceed a net doping of 8E12 At/cm⁻².

13. Method according to claim 7, **characterised in that** the LDMOS transistor is produced jointly with standard transistors, in which lateral insulation (15), a gate oxide (11), the control gate (9) and highly doped source/drain regions (3, 5) of the LDMOS transistor are produced in a CMOS standard process and resemble the lateral insulation, the gate oxide, the control gate and the highly doped source/drain regions of the corresponding components of standard transistors.

14. Method according to claim 13, wherein a doping zone (7) of the opposite conductivity type, hereinafter referred to as the well region, which extends into the drift chamber (20) and affects the threshold voltage and short channel characteristics of the transistor, is produced jointly with corresponding well regions of the standard transistors, while the more highly doped region (26) of the second LDD region immediately adjoining the control gate is pre-doped first of all using a separate paint mask by means of a separate ion implant or a number of separate ion implants and then to complete the doping of the LDD region (22, 26) and the covering layer (24) in the drift chamber two or more further maskless ion implants are carried out.

15. Method according to claim 13, **characterised in that** in an active region of the LDMOS transistor the standard well doping carried out before the production of the polygate (9) is dispensed with by a suitable design of an associated paint mask and that the well region projecting into the drift chamber is doped using a separate paint mask together with the more highly doped area of the LDD region (22, 26) immediately adj acent to the control gate by a sequence of ion implants of different conductivity types depending on the structuring of polygates and that therefore two or more additional maskless ion implants complete the doping of the first LDD region and the covering layer (24) in the drift chamber.

16. Method according to claim 15, **characterised in that** the well region (7) projecting into the drift chamber (20) is produced by the combination of a standard halo implant with an additional implant of greater depth of penetration of dopants of the same conductivity type through a separate paint mask, while the doping of the second LDD region (26) immediately adjacent to the control gate (9) is carried out through the same paint mask.

17. Method according to claim 15 or 16, **characterised in that** by matching the height of the mask, the implant angle and energy in the additional well implant through a separate paint mask, sufficient shading of the well implant is achieved in the vicinity of a mask edge on the drain side to ensure overlapping, on the drain side, of the more highly doped LDD region (26) over the well region (7) and avoid a potential barrier in the drift chamber that increases the "on" resistance.

18. Method according to claim 15 or 16, **characterised in that** a potential barrier is avoided by the fact that after the additional well implant, through a separate paint mask, an isotropic removal of paint is carried out with a corresponding lateral displacement of a paint edge, before the implanting of the more highly doped second LDD region (26).

## Revendications

1. Transistor LDMOS comportant une région de source (3), une région de drain (5), une grille de commande (9) ainsi qu'une région de dérive (20) s'étendant entre la région de drain (5) et la grille de commande (9), dans lequel, dans la région de dérive (20) est formée une première zone LDD (22) du même type de conductivité que celui de la région de drain (5) et au-dessus de la première zone LDD (22) est prévue une couche de finition (24), qui présente le type de conductivité opposé au type de conductivité de la première zone LDD (22), **caractérisé en ce que** la couche de finition (24) est remplacée à l'extrémité côté grille de la première zone LDD (22) par une seconde zone LDD (26) du même type de conductivité que celui de la région de drain (5) et est prévue avec un dopage plus élevé par rapport à la première zone LDD (22).

2. Transistor LDMOS selon la revendication 1, **caractérisé en ce que** la concentration en dopant concernant la surface ne dépasse pas une valeur de 1x10¹³cm⁻² dans la première couche LDD (22) et la concentration en dopant concernant la surface ne dépasse pas une valeur de 8x10¹²cm⁻² dans la couche de finition (24).

3. Transistor LDMOS selon l'une des revendications 1 à 2, **caractérisé en ce qu'**un puits de type p fortement dopé (7) est prévu, qui s'étend en dessous de la région de source (3), en dessous de la grille de commande (9) ainsi qu'en dessous d'une partie de la première zone LDD (22).

4. Transistor LDMOS selon la revendication 3, **caractérisé en ce que** le puits de type p (7) est recouvert par la plus grande partie de ce tronçon de la première zone LDD (22), dans lequel est formée la seconde zone LDD (26).

5. Transistor LDMOS selon l'une des revendications précédentes, **caractérisé en ce que** les concentrations en dopant dans la première zone LDD (22), dans la couche (24) ainsi que dans la seconde zone LDD (26) sont choisies de sorte que la première zone LDD (22) et la seconde zone LDD (26) sont complètement appauvries en porteurs de charge, lorsqu'aucune tension ne se trouve à la grille de commande (9) et qu'il existe une tension de drain, qui est plus petite que la tension de claquage BV_{DS} de la région de drain (5).

6. Transistor LDMOS selon la revendication 5, **caractérisé en ce que** la première zone LDD (22) et la seconde zone LDD (26) sont complètement appauvries en porteurs de charge au moins dans la zone de recouvrement par le puits de type p (7), lorsqu'il n'existe aucune tension à la grille de commande et qu'il existe une tension de drain de 2 à 2,5 volts.

7. Procédé de fabrication d'un transistor LDMOS compatible CMOS, dans lequel, dans la zone de la région de dérive (20) se trouvant entre une région de drain (5) et une grille de commande (9) au-dessus d'une zone LDD (22, 26) est disposée une zone de dopage (24) plane en comparaison des enfoncements des régions de source/drain (3, 5) en tant que couche de finition d'un type de conduction inverse à la zone LDD (22, 26) dans lequel la couche de finition est formée lors d'une seconde étape parmi les deux étapes d'implantation supplémentaires par rapport à un processus CMOS standard lors d'une suite de procédés, **caractérisé en ce que** dans une première étape sur les deux étapes d'implantation supplémentaires lors d'une suite de procédés, une seconde zone LDD (26) du même type de conductivité que celui de la région de drain (5) et avec un dopage plus élevé par rapport à la première zone LDD (22) est formée à l'extrémité côté grille de la première zone LDD (22).

8. Procédé selon la revendication 7, **caractérisé en ce que** la première étape d'implantation supplémentaire est effectuée après la formation de la grille de commande (9) et avant la formation d'un dispositif d'espacement de grille (10) et la seconde étape d'implantation est effectuée après la formation du dispositif d'espacement de grille (10).

9. Procédé selon la revendication 8, **caractérisé en ce que,** lors de la première étape d'implantation supplémentaire en vue de la formation de la seconde zone LDD (26) est utilisé un masque, dont la fenêtre s'étend du bord de grille en direction de la région de drain (5), dans lequel un petit tronçon de la fenêtre fait saillie au-dessus de la zone, dans laquelle le puits de type p (7) est formé.

10. Procédé selon l'une des revendications 7 à 9, **caractérisé en ce que** la seconde étape d'implantation supplémentaire est effectuée sans masque.

11. Procédé selon l'une des revendications 7 à 10, **caractérisé en ce que** la fabrication de la couche de finition (24) est effectuée avec une énergie et une dose, qui sont choisies de sorte que la première zone LDD (22) s'appauvrit complètement en supports de conducteurs dans le cas d'une conductivité la plus élevée possible au moins dans la zone, dans laquelle elle est recouverte par le puits de type p (7), déjà dans le cas d'une tension de drain de 2 à 2,5 volts.

12. Procédé selon la revendication 7, dans lequel le un dopage net concernant la surface dans la couche de finition est ajusté, qui est inférieur au dopage net de la zone LDD (22, 26) et qui ne dépasse pas un dopage net de 8E12 At/cm⁻².

13. Procédé selon la revendication 7, **caractérisé en ce que** le transistor LDMOS est fabriqué conjointement avec des transistors standards, dans lequel une isolation latérale (15), un oxyde de grille (11), la grille de commande (9) et des régions de source/drain fortement dopées (3, 5) du transistor LDMOS sont fabriqués lors d'un processus CMOS standard et l'isolation latérale, l'oxyde de grille, la grille de commande et les régions de source/drain fortement dopées sont les mêmes que les composants correspondants des transistors standards.

14. Procédé selon la revendication 13, dans lequel une zone de dopage (7) faisant saillie dans la région de dérive (20), et influençant la tension de seuil et le comportement de canal court du transistor et de type de conduction opposée, qui est décrit ci-après par région de puits, est fabriquée conjointement avec les régions de puits correspondantes des transistors standards, dans lequel la zone (26) fortement dopée et immédiatement reliée à la grille de commande de la seconde zone LDD est préalablement dopée tout d'abord par un masque de vernis particulier au moyen d'une implantation ionique distincte ou de plusieurs implantations ioniques distinctes et ensuite deux ou plusieurs autres implantations ioniques sans masque sont effectuées dans la région de dérive en vue d'achever le dopage de la zone LDD (22, 26) et de la couche de finition (24).

15. Procédé selon la revendication 13, **caractérisé en ce que**, dans une zone active du transistor LDMOS, un dopage de puits standard se produisant avant la fabrication d'une grille en silicium polycristallin (9) est évidé par une réalisation correspondante d'un masque de vernis associé et **en ce que** la région de puits faisant saillie dans la région de dérive (20) est dopée par un masque de vernis particulier conjointement avec la zone fortement dopée et reliée immédiatement à la grille de commande de la zone LDD (22, 26) par une série d'implantations ioniques d'un type de conduction différent selon la structure de la grille en silicium polycristallin et **en ce que**, ensuite, deux ou plusieurs autres implantations ioniques sans masque achèvent le dopage de la première zone LDD et de la couche de finition (24) dans la région de dérive.

16. Procédé selon la revendication 15, **caractérisé en ce que** la région de puits (7) faisant saillie dans la région de dérive (20) est produite par la combinaison d'une implantation par halo standard et d'une implantation supplémentaire d'une profondeur de pénétration plus élevée de dopants du même type de conduction au moyen d'un masque de vernis particulier, dans lequel le dopage de la seconde zone LDD (26) immédiatement reliée à la grille de commande (9) est effectué par le même masque de vernis.

17. Procédé selon la revendication 15 ou 16, **caractérisé en ce que,** grâce à une concordance de hauteur de masque, d'angle d'implantation et d'énergie lors de l'implantation de puits supplémentaire par un masque de vernis particulier, un assombrissement suffisant de l'implantation de puits à proximité d'un bord de masque côté drain est obtenu, de sorte qu'un recouvrement côté drain de la zone LDD fortement dopée (26) est assuré par la région de puits (7) et une barrière de potentiel augmentant la résistance "passante" est évitée dans la région de dérive.

18. Procédé selon la revendication 15 ou 16, **caractérisé en ce qu'**une barrière de potentiel est évitée **en ce que**, après l'implantation de puits supplémentaire par un vernis de masque particulier avant l'implantation de la seconde zone LDD (26) fortement dopée, il se produit un manque de vernis isotrope avec un décalage latéral correspondant un bord du vernis.
